# EUROPEAN PATENT APPLICATION

(11) **EP 4 053 214 A1**
(43) Date of publication of application: **07.09.2022**
(21) Application number: 20899432.7
(22) Date of filing: 25.11.2020
(51) Int. Cl.: C08L 63/00, C08K 5/1515

(54) **COMPOSITION, CURABLE COMPOSITION, AND CURED PRODUCT**

(30) Priority: 12.12.2019 JP 2019224802
(71) Applicant: Daikin Industries, Ltd., Osaka-shi, Osaka 530-8323 (JP)
(72) Inventor: TANAKA, Yoshito, Osaka-Shi, Osaka 530-8323 (JP); YOSHIYAMA, Asako, Osaka-Shi, Osaka 530-8323 (JP); KISHIKAWA, Yosuke, Osaka-Shi, Osaka 530-8323 (JP)
(74) Representative: Hoffmann Eitle
(86) International application number: PCT/JP2020/043831
(87) International publication number: WO 2021/117486

(57) **Abstract**

Provided is a composition having excellent compatibility with a fluorine-free epoxy resin even though the composition contains a fluorine-containing epoxy resin. The composition contains:
a compound (D) represented by the following formula (D): 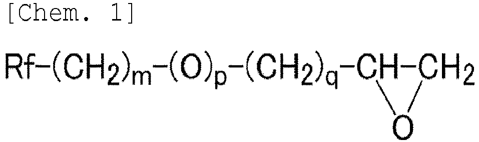 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom, and a compound (E) represented by the following formula (E): 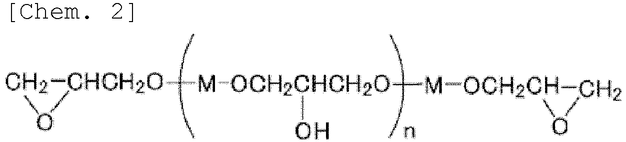 wherein n is an integer of 0 or greater; and M is a group represented by the following formula (E1): 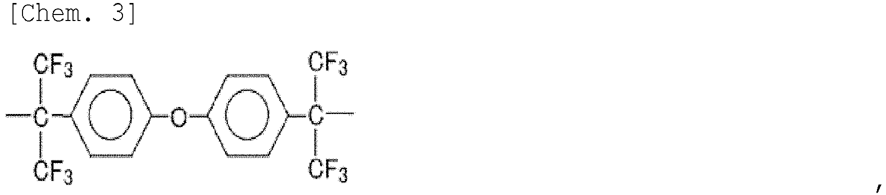 a group represented by the following formula (E2): 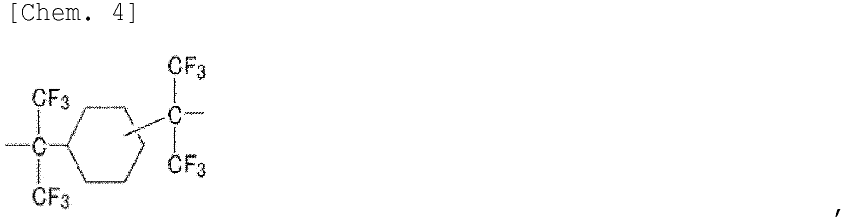 or a group represented by the following formula (E3): 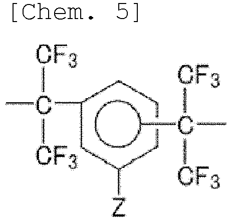 wherein Z is hydrogen or a C1-C10 fluoroalkyl group.

## Description

### TECHNICAL FIELD

The disclosure relates to compositions, curable compositions, and cured products.

### BACKGROUND ART

Patent Literature 1 discloses a positive photosensitive resin composition containing at least a copolymer with at least two components of styrene and maleic acid amide, a 1,2-naphthoquinonediazide group-containing compound, a cross-linking agent, and a silane coupling agent. Patent Literature 2 discloses a negative photosensitive resin composition containing a copolymer with at least two components of styrene and maleic acid amide, a polymerizable monomer, and a photopolymerization initiator. Patent Literature 3 discloses a negative photosensitive resin composition containing a copolymer with at least two components of styrene and maleic acid amide, a melamine compound, and a photoacid generator, and states that the composition may contain a fluorinated aromatic epoxy compound or a fluorinated aliphatic compound. Patent Literature 3, however, does not mention that the fluorinated aromatic epoxy compound and the fluorinated aliphatic compound are used in combination.

Patent Literature 4 discloses an adhesive formulation for bonding materials, containing 40 to 80% by weight of an epoxy monomer; 15 to 30% by weight of an oxetane monomer; 0.1 to 10% by weight of an adhesion promotor; 0.1 to 5% by weight of a sensitizer; and 1 to 10% by weight of a radiation and temperature activable photoinitiator or a mixture of a photoinitiator and a thermal initiator. Patent Literature 4 merely mentions an adhesive formulation containing 3-perfluorooctyl-1,2-propenoxide as a fluorinated epoxy monomer.

### CITATION LIST

### - Patent Literature

Patent Literature 1: JP 2001-242616 A
Patent Literature 2: JP 2001-242617 A
Patent Literature 3: JP 2001-242624 A
Patent Literature 4: JP 2019-522685 T

### SUMMARY OF INVENTION

### - Technical Problem

The disclosure provides a composition having excellent compatibility with a fluorine-free epoxy resin even though the composition contains a fluorine-containing epoxy compound.

### - Solution to Problem

The disclosure relates to a composition containing a compound (D) represented by the following formula (D): 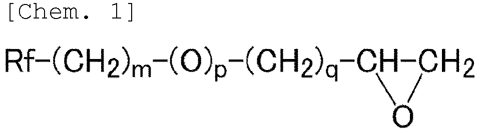 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom; and
a compound (E) represented by the following formula (E) : 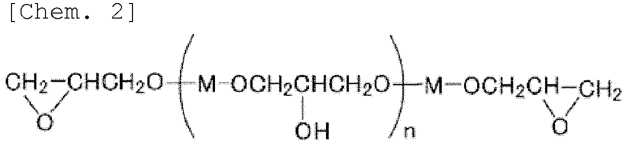 wherein n is an integer of 0 or greater; and M is a group represented by the following formula (E1): 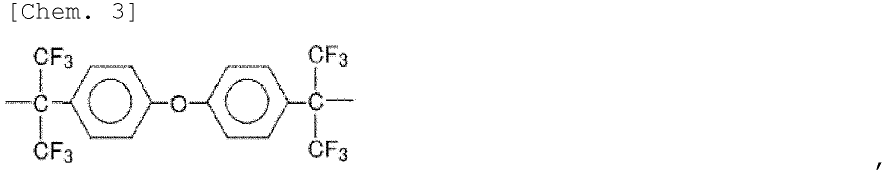 a group represented by the following formula (E2): 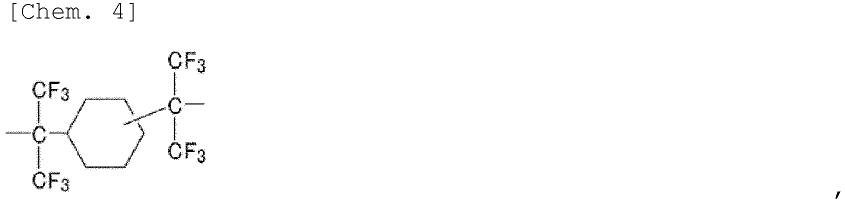 or a group represented by the following formula (E3): 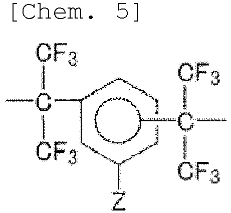 wherein Z is hydrogen or a C1-C10 fluoroalkyl group.

Preferably, M is a group represented by the following formula (E2):

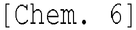

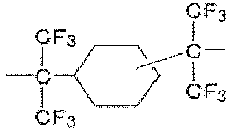

Preferably, Rf is a C6 linear perfluoroalkyl group.

Preferably, in the composition of the disclosure, the compound (D) represents 5 to 95% by mass of 100% by mass in total of the compound (D) and the compound (E).

Preferably, the composition of the disclosure has an organic solvent content of 1% by mass or lower.

The disclosure also provides a curable composition including the composition and a curing agent.

Preferably, the curing agent includes at least one selected from the group consisting of an acid anhydride, an amine, an isocyanate, an amide, an imidazole, and a mercaptan.

Preferably, the curable composition of the disclosure further contains a fluorine-free epoxy resin.

The disclosure further provides a cured product obtainable by curing the curable composition.

Preferably, the cured product is an electronic material.

The disclosure also provides a composition containing:
a compound (D) represented by the following formula (D) : 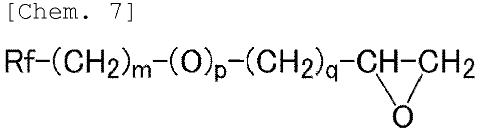 wherein m is an integer of 0 to 6; p is 0 or 1; q is an integer of 0 to 6; and Rf is a C1-C8 perfluoroalkyl group optionally containing oxygen with one fluorine atom being optionally replaced by a hydrogen atom; and
a compatibilizer,
the composition having a fluorine content of 45% by mass or higher.

Preferably, the compatibilizer is a fluorine-containing compound containing two or more epoxy groups and an aromatic ring or cyclohexane ring in a molecular structure.

### - Advantageous Effects of Invention

The composition of the disclosure has excellent compatibility with a fluorine-free epoxy resin even though the composition contains a fluorine-containing epoxy compound.

### DESCRIPTION OF EMBODIMENTS

Resins such as phenolic resins, epoxy resins, and polyimide resins have been used for stacking materials for a multi-layer printed wiring board. In the trend where computers execute operations at higher speed, there has been a strong demand for a higher signal propagation speed of multi-layer printed wiring boards. Satellite communication systems and mobile radio systems utilize high frequencies in the gigahertz (GHz) band. Thus, materials of printed wiring boards for transmission and reception devices of such systems are to have excellent high-frequency-transmission properties. Under such circumstances, materials having a lower permittivity and a lower loss tangent than conventional materials have been awaited. At the same time, the materials are desired to achieve cost reduction. However, a material that satisfies both demands has not been found. As a result of intensive studies by the present disclosers, a composition containing two specific fluorine-containing epoxy compounds was found to have excellent compatibility with a fluorine-free epoxy resin and exhibit excellent electrical properties (low permittivity and low loss tangent) while achieving cost reduction when used together with a fluorine-free epoxy compound. Thus, the composition of the disclosure was completed.

The composition of the disclosure (hereinafter, also referred to as "the first composition of the disclosure") contains a compound (D) represented by the following formula (D): 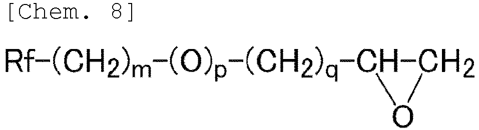 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom; and
a compound (E) represented by the following formula (E) : 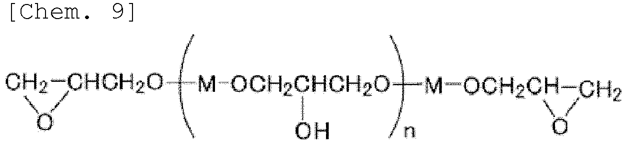 wherein n is an integer of 0 or greater; and M is a group represented by the following formula (E1): 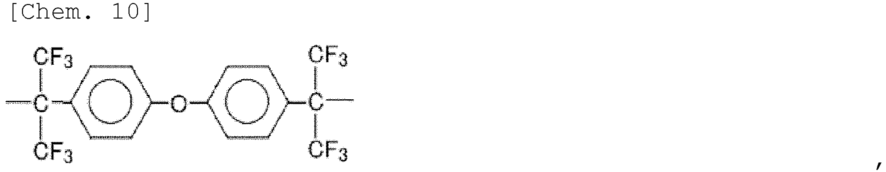 a group represented by the following formula (E2): 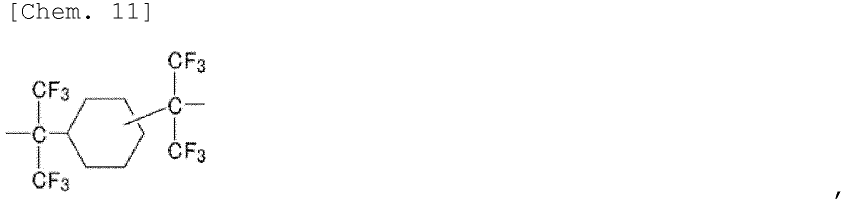 or a group represented by the following formula (E3): 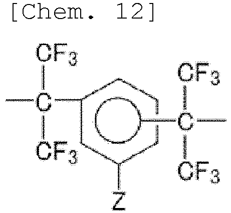 wherein Z is hydrogen or a C1-C10 fluoroalkyl group.

The first composition of the disclosure having the above structure has excellent compatibility with a fluorine-free epoxy resin even though the composition contains a fluorine-containing epoxy compound. Thus, the first composition, when forming a compatible blend with an inexpensive fluorine-free epoxy resin, can achieve cost reduction while having excellent characteristics of the fluorine-containing compound. Also, the compound (D) is relatively inexpensive. The first composition therefore achieves cost reduction while increasing the fluorine content owing to the combination of the compound (D) and the compound (E) and is imparted with a low permittivity and a low loss tangent when blended with a fluorine-free epoxy resin. In addition, the first composition can achieve excellent mechanical strength and excellent heat resistance, for example, owing to the compound (E).

The compound (D) is a compound represented by the following formula (D): 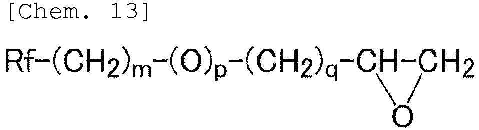 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom.

In the formula (D), m is preferably an integer of 0 to 4, more preferably 0, 1, or 2, still more preferably 0, in terms of high fluorine content.

In the formula (D), p is preferably 0, in terms of high fluorine content, mechanical strength, low permittivity, and low loss tangent.

In the formula (D), q is preferably an integer of 0 to 4, more preferably 0, 1, or 2, still more preferably 1, in terms of high fluorine content.

The sum of m and q is preferably an integer of 0 to 12, more preferably an integer of 0 to 6, still more preferably an integer of 0 to 4, even more preferably 0, 1, or 2, particularly preferably 1.

In the formula (D), Rf is a C1-C8 perfluoroalkyl group optionally containing oxygen with one fluorine atom being optionally replaced by a hydrogen atom.

The carbon number of Rf is preferably 2 to 6, more preferably 3 to 6, still more preferably 4 to 6. Rf is a perfluoroalkyl group with one fluorine atom being optionally replaced by a hydrogen atom, preferably a perfluoroalkyl group with no fluorine atom being replaced by a hydrogen atom.

Specific examples of Rf include CF₃(CF₂)₅-, CF₃(CF₂)₄-, CF₃(CF₂)₃-, CF₃(CF₂)₂-, CF₃CF₂-, CF₃-, HCF₂(CF₂)₅-, HCF₂(CF₂)₃-, and HCF₂CF₂-. From the viewpoints of low permittivity and low loss tangent, Rf is preferably CF₃(CF₂)₅-, CF₃(CF₂)₄-, or CF₃(CF₂)₃-, more preferably CF₃(CF₂)₅-. In other words, Rf is preferably a C6 linear perfluoroalkyl group.

The compound (D) preferably has a fluorine content of 50% by mass or higher, more preferably 55% by mass or higher, still more preferably 60% by mass or higher, particularly preferably 65% by mass or higher, in order to obtain a composition having a lower permittivity and a lower loss tangent. From the viewpoint of mechanical strength, the fluorine content may be 80% by mass or lower or may be 75% by mass or lower.

Preferred specific examples of the compound (D) include compounds represented by the following chemical formulas. These compounds may be used alone or in combination of two or more thereof.

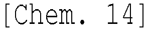

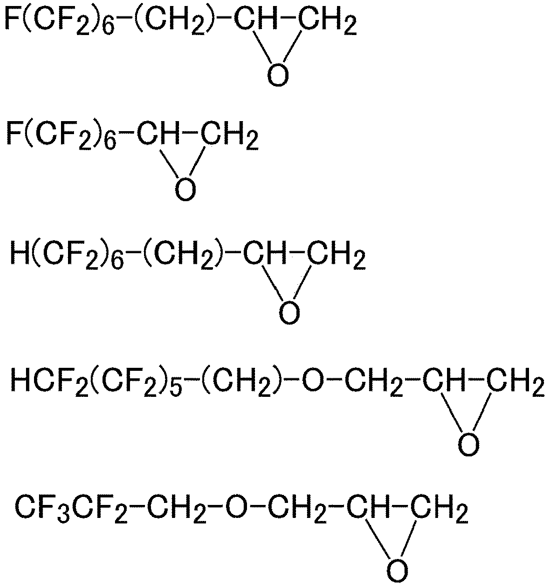

In particular, the compound (D) is preferably the compound represented by the following chemical formula.

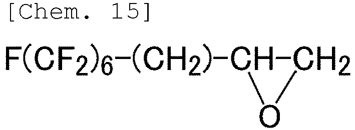

The compound (E) is a compound represented by the formula (E). M in the formula (E) is preferably the group represented by the formula (E1) or the group represented by the formula (E2), more preferably the group represented by the formula (E2).

Preferably, M is the group represented by the formula (E2) having a mole ratio of the 1,3-isomer and the 1,4-isomer of the group represented by the formula (E2) (1,3-isomer/1,4-isomer) of 0/100 to 100/0. The mole ratio (1,3-isomer/1,4-isomer) is more preferably 95/5 to 50/50, still more preferably 95/5 to 70/30, particularly preferably 95/5 to 80/20.

The 1,3-isomer and the 1,4-isomer of the group represented by the formula (E2) have the following respective structures.

1,3-Isomer of the group represented by the formula (E2)

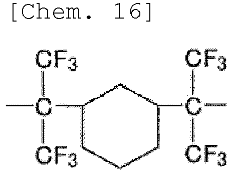

1,4-Isomer of the group represented by the formula (E2)

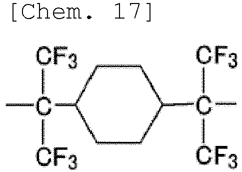

In the formula (E), n is an integer of 0 or greater. Preferably, n is an integer of 0 to 10, and is usually 0, 1, or 2 in terms of mechanical strength and heat resistance.

In the formula (E), the average value of n is not limited, but is preferably 0.5 or smaller, more preferably 0.3 or smaller, still more preferably 0.2 or smaller, even more preferably 0.18 or smaller, particularly preferably 0.16 or smaller, in terms of low permittivity and low loss tangent. In terms of mechanical properties and adhesiveness of the cured product, the average value of n is preferably 0 or greater, more preferably 0.08 or greater, still more preferably 0.09 or greater, even more preferably 0.1 or greater. The average value of n may be 0.

The n is the value determined from the area ratio in gel permeation chromatography (GPC).

For example, when the area ratio of a compound having a value n of 0 is 0.93, the area ratio of a compound having a value n of 1 is 0.06, and the area ratio of a compound having a value n of 2 is 0.01 relative to the entire area of the compounds in the formula (E), the average value of n is 0.08 (= 1*0.06 + 2*0.01).

GPC may be performed under any conditions, such as a condition using Shodex KF-801 and KF-802 each having a length of 30 cm as columns and chloroform as a developing solvent.

The compound (E) preferably has an epoxy equivalent of 250 or more in terms of low permittivity and low loss tangent. The epoxy equivalent is more preferably 260 or more, still more preferably 265 or more. In terms of adhesion to a substrate, the epoxy equivalent is preferably 310 or less, more preferably 300 or less.

The epoxy equivalent is the value determined by the method in conformity with JIS K-7236.

The compound (E) preferably has a glass transition temperature of 100°C to 200°C. The glass transition temperature is more preferably 110°C or higher, still more preferably 120°C or higher, even more preferably 125°C or higher. The glass transition temperature may be 170°C or lower.

The glass transition temperature is the temperature at the middle point of an endothermic curve of second run, the endothermic curve being obtained by performing temperature rising (first run) - temperature dropping - temperature rising (second run) at a temperature-changing rate of 10°C/min in a temperature range from 30°C to 250°C using a differential scanning calorimeter (DSC, available from SEIKO, RTG220).

The compound (E) preferably has a coefficient of linear expansion of 150 ppm or less. The coefficient of linear expansion is more preferably 100 ppm or less, still more preferably 70 ppm or less, particularly preferably 60 ppm or less. The lower limit of the coefficient of linear expansion is not particularly limited, and may be, for example, 10 ppm or more.

The coefficient of linear expansion is the value determined by thermomechanical analysis (TMA).

The compound (E) preferably has a relative permittivity of 3.8 or lower, more preferably 3.4 or lower, particularly preferably 3.3 or lower. The lower limit of the relative permittivity may be, but is not limited to, 2.2 or higher or 2.4 or higher, for example.

The relative permittivity is the value calculated by determining the capacitance with an LCR meter at 25°C and a frequency of 1 kHz.

The compound (E) preferably has a loss tangent of 0.05 or lower, more preferably 0.03 or lower, still more preferably 0.02 or lower, particularly preferably 0.01 or lower. The lower limit of the loss tangent may be, but is not limited to, 0.001 or higher or 0.002 or higher, for example.

The loss tangent is the value measured with an LCR meter at 25°C and a frequency of 1 kHz.

The compound (E) preferably has a refractive index of 1.38 to 1.50, more preferably 1.45 or lower, still more preferably 1.43 or lower, while it may be 1.40 or higher or 1.41 or higher.

The refractive index is the value measured with an Abbe refractometer.

The glass transition temperature, coefficient of linear expansion, relative permittivity, loss tangent, and refractive index are the values of a specimen obtained by adding 2 parts by mass of 2-ethyl-4-methyl imidazole to 100 parts by mass of the compound (D) or (E), heating the components to 50°C, uniformly mixing it to provide a curable composition, and curing the composition at 200°C for five hours.

The compound (E) can be obtained by, for example, reacting a fluorine-containing diol represented by the following formula (G):

HO-M-OH

wherein M is defined as described above, with epichlorohydrin.

The compound (E) can also be obtained by a method for producing a fluorine-containing epoxy resin, including reacting a fluorine-containing diol represented by the following formula (G):

HO-M-OH

wherein M is defined as described above, with a compound containing a double bond to provide a fluorine-containing olefin containing two double bonds, and oxidizing the fluorine-containing olefin to provide a fluorine-containing epoxy resin. This production method can provide a fluorine-containing epoxy resin having a value of n in the formula (E) of 0.

The compound containing a double bond may be any compound that contains a double bond in the molecule structure and reacts with the hydroxy groups of the fluorine-containing diol to provide the fluorine-containing olefin, and a preferred example thereof is a compound represented by CH₂=CH-R, wherein R is an organic group or a silyl group.

Examples of the R include a C1-C10 alkyl group in which one or some of the hydrogen atoms bonded to a carbon atom is/are replaced by halogen atom(s), a C1-C10 hydroxyalkyl group, a C1-C10 silylalkyl group, and a silyl group.

Specific examples of the compound containing a double bond include halogenated allyls such as allyl chloride and allyl bromide and compounds such as allyl alcohol and allyl silane.

The step of providing a fluorine-containing olefin may be any step that includes reacting the hydroxy groups of a fluorine-containing diol with a compound containing a double bond to provide a fluorine-containing olefin, and the step may be performed at 20°C to 80°C, preferably at 30°C to 60°C.

In the step of oxidizing the fluorine-containing olefin to provide a fluorine-containing epoxy resin, the oxidization can be performed by reacting the fluorine-containing olefin with an oxidant. Specifically, the oxidization can be performed by adding an oxidant to a reaction container filled with the fluorine-containing olefin.

The oxidant may be any oxidant that can oxidize and thereby convert the double bond of the fluorine-containing olefin into an epoxy group, and examples thereof include hydrogen peroxide and acetyl hydroperoxide.

The amount of the oxidant used is preferably 2 to 5 mol, more preferably 2.1 to 3 mol relative to 1 mol of the fluorine-containing olefin.

The fluorine-containing olefin is preferably oxidized at 30°C or higher, more preferably 40°C or higher, while preferably 80°C or lower, more preferably 70°C or lower.

The first composition of the disclosure contains a compound represented by the following formula (F): 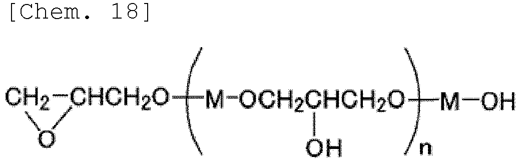 wherein M and n are defined as described above, in an amount of preferably 0 to 10% by mass, more preferably 0 to 5% by mass, still more preferably 0 to 3% by mass, particularly preferably 0 to 2% by mass, relative to the total amount of the compound represented by the formula (F) and the compound (E). The amount of the compound represented by the above formula (F) may be 0.0001% by mass or more, 0.001% by mass or more, 0.01% by mass or more, or 0.1% by mass or more, relative to the total amount of the compound represented by the formula (F) and the compound (E) .

In the production process of the compound (E), a compound represented by the formula (F) having an epoxy group at one end and a hydroxy group at the other end may be generated. In such a case, the first composition of the disclosure may contain the compound represented by the formula (F) in an amount within the above range.

The first composition of the disclosure contains a fluorine-containing diol represented by the following formula (G):

HO-M-OH

wherein M is defined as described above, in an amount of preferably 0 to 10% by mass, more preferably 0 to 5% by mass, still more preferably 0 to 3% by mass, particularly preferably 0 to 2% by mass, relative to the total amount of the fluorine-containing diol and the compound (E). The amount of the fluorine-containing diol may be 0.01% by mass or more or 0.1% by mass or more, relative to the total amount of the fluorine-containing diol and the compound (E).

The compound (E) can be produced from the compound represented by the formula (G) as a raw material, but in such a case, the compound represented by the formula (G) as a raw material may remain in the compound (E). The first composition of the disclosure may contain the compound represented by the formula (G) in an amount within the above range.

The first composition of the disclosure contains the compound (D) in an amount of 5 to 95% by mass, more preferably 20 to 65% by mass, of 100% by mass in total of the compound (D) and the compound (E), in terms of low permittivity, low loss tangent, compatibility, and mechanical strength. The amount is still more preferably 25 to 63% by mass, even more preferably 40 to 63% by mass, particularly preferably 50 to 60% by mass.

The first composition of the disclosure preferably has a fluorine content of 45% by mass or higher, more preferably 47% by mass or higher, still more preferably 50% by mass or higher, in terms of low permittivity and low loss tangent. A higher fluorine content is more preferred in terms of low permittivity and low loss tangent. However, a high fluorine content reduces compatibility. Thus, the fluorine content is, for example, preferably 65% by mass or lower, more preferably 60% by mass or lower, still more preferably 58% by mass or lower.

The first composition of the disclosure preferably has an organic solvent content of 1% by mass or lower. The first composition of the disclosure can form a compatible blend with a fluorine-free epoxy resin as described later even when having an organic solvent content of 1% by mass or lower. The organic solvent content may be 0.5% by mass or lower, 0.3% by mass or lower, 0.1% by mass or lower, 0.01% by mass or lower, or substantially 0% by mass.

Examples of the organic solvent include toluene, xylene, acetone, methyl ethyl ketone, methyl isobutyl ketone, ethyl acetate, dimethyl formamide, and N-methylpyrrolidone. These may be used alone or in combination of two or more thereof.

The first composition of the disclosure may contain the compound (D) and the compound (E) in a total amount of 50% by mass or higher, 70% by mass or higher, 90% by mass or higher, 95% by mass or higher, or substantially 100% by mass, relative to the total mass of the composition.

The composition of the disclosure (hereinafter, also referred to as "the second composition of the disclosure") contains a compound (D) represented by the following formula (D): 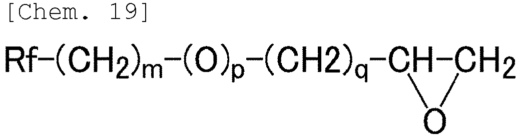 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom; and a compatibilizer, and has a fluorine content of 45% by mass or higher. The second composition of the disclosure having the above structure has excellent compatibility with a fluorine-free epoxy resin even though the composition contains a fluorine-containing epoxy compound. Thus, the second composition, when forming a compatible blend with an inexpensive fluorine-free epoxy resin, can achieve cost reduction while having excellent characteristics of the fluorine-containing compound. Also, the compound (D) is relatively inexpensive. The second composition therefore achieves cost reduction while increasing the fluorine content owing to the combination of the compound (D) and the compatibilizer and exhibit better electrical properties (low permittivity and low loss tangent).

The compound (D) is the same as that in the first composition of the disclosure, and may be in any mode of the compound (D) described for the first composition.

The compatibilizer is preferably a compound that imparts a transmittance of 90% or higher to a composition consisting of 40% by mass of the compound (D), 40% by mass of the compatibilizer, and 20% by mass of 2,2-bis(4-glycidyloxyphenyl)propane or 3',4'-epoxycyclohexylmethyl 3,4-epoxycyclohexanecarboxylate. The transmittance is more preferably 95% or higher, still more preferably 98% or higher. The transmittance has only to be 90% or higher in one of the case of using 2,2-bis(4-glycidyloxyphenyl)propane or the case of using 3',4'-epoxycyclohexylmethyl 3,4-epoxycyclohexanecarboxylate, and may be lower than 90% in the other case.

The transmittance is the value obtained by pouring a composition containing the compound (D), the compatibilizer, and 2,2-bis(4-glycidyloxyphenyl)propane or 3',4'-epoxycyclohexylmethyl 3,4-epoxycyclohexanecarboxylate into a 1-cm-square cell made of quartz, and measuring the transmittance at 550 nm.

Preferably, the compatibilizer is a fluorine-containing compound containing two or more epoxy groups and an aromatic ring or cyclohexane ring in a molecular structure. The number of epoxy groups is preferably 5 or smaller, more preferably 2 or 3, still more preferably 2. The aromatic ring is represented by the following formula:

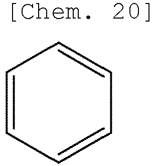

The cyclohexane ring is represented by the following formula:

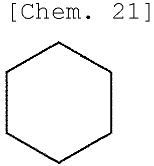

The compatibilizer is preferably the compound (E) represented by the formula (E). The compound (E) is the same as that in the first composition of the disclosure, and may be in any mode of the compound (E) described for the first composition. For example, M in the formula (E) is preferably the group represented by the formula (E1) or the group represented by the formula (E2), more preferably the group represented by the formula (E2).

Also, the second composition of the disclosure may contain a compound represented by the formula (F) and a compound represented by the formula (G) in the same amounts as those in the first composition of the disclosure.

The second composition of the disclosure contains the compound (D) in an amount of 5 to 95% by mass, more preferably 20 to 65% by mass, of 100% by mass in total of the compound (D) and the compatibilizer, in terms of low permittivity, compatibility, and mechanical strength. The amount is still more preferably 25 to 63% by mass, even more preferably 40 to 63% by mass, particularly preferably 50 to 60% by mass.

The second composition of the disclosure preferably has a fluorine content of 45% by mass or higher. The fluorine content is more preferably 47% by mass or higher, still more preferably 50% by mass or higher, in terms of low permittivity. A higher fluorine content is more preferred. However, a high fluorine content reduces compatibility. Thus, the fluorine content may be, for example, 65% by mass or lower, 60% by mass or lower, or 58% by mass or lower.

The second composition of the disclosure preferably has an organic solvent content of 1% by mass or lower. The second composition of the disclosure can form a compatible blend with a fluorine-free epoxy resin as described later even when having an organic solvent content of 1% by mass or lower. The organic solvent content may be 0.5% by mass or lower, 0.3% by mass or lower, 0.1% by mass or lower, 0.01% by mass or lower, or substantially 0% by mass.

Examples of the organic solvent include toluene, xylene, acetone, methyl ethyl ketone, methyl isobutyl ketone, ethyl acetate, dimethyl formamide, and N-methylpyrrolidone. These may be used alone or in combination of two or more thereof.

The second composition of the disclosure may contain the compound (D) and the compatibilizer in a total amount of 50% by mass or higher, 70% by mass or higher, 90% by mass or higher, 95% by mass or higher, or substantially 100% by mass, relative to the total mass of the composition.

The first and second compositions of the disclosure each preferably have a transmittance of 70% or higher. The transmittance is more preferably 75% or higher, still more preferably 80% or higher, particularly preferably 85% or higher. A higher transmittance is more preferred. The upper limit of the transmittance may be 100%.

The first and second compositions of the disclosure may each contain an additive as well as the compound (D) and the compound (E) or the compatibilizer. Examples of the additive include antioxidants, antistatic agents, colorants, and antifungal agents. The amount of the additive in each composition is preferably 5 parts by mass or less, more preferably 3 parts by mass or less, relative to 100 parts by mass in total of the compound (D) and the compound (E) or the compatibilizer. The amount of the additive may be 0 parts by mass.

The first and second compositions of the disclosure, each containing the compound (D) and the compound (E), can lower the permittivity and improve other properties, and are suitable as a material for electronic materials, particularly low permittivity materials. The disclosure relates to use of the first or second composition as a low permittivity material.

Since the first and second compositions of the disclosure have excellent compatibility with a fluorine-free epoxy resin, the compositions can achieve cost reduction when used together with the fluorine-free epoxy resin. The first and second compositions of the disclosure may be mixed with a curing agent, so that they may be used as low permittivity materials as they are. The first and second compositions of the disclosure may further contain a curing agent. The curing agent may be any curing agent mentioned for the later-described curable composition.

The first and second compositions of the disclosure may each be applied to any electronic component and each are useful for high-frequency printed boards that are to have high frequency properties. Examples of high-frequency printed boards include substrates of electronic devices such as an antenna, a radar system, a router in networking, a backplane, and a wireless infrastructure; substrates for automotive sensors; and substrates for engine management sensors. The first and second compositions each are particularly suitable for applications for reducing the transmission loss in the millimeter-wave band.

Also, the first and second compositions of the disclosure can each be used for a paste, a B-stage film, and an electronic material for resin-coated copper foil or a prepreg for a printed board, particularly for a high-frequency multilayer substrate and a buildup insulating material.

The disclosure also provides a composition containing the first or second composition of the disclosure and a fluorine-free epoxy resin. Since the first or second composition of the disclosure has excellent compatibility with a fluorine-free epoxy resin, the first or second composition can form a composition having high uniformity and high transparency without an organic solvent. Also, the composition is uniformly mixed, thus being curable into a uniformly cured product. The amount of the fluorine-free epoxy resin is preferably 5 parts by mass or more, more preferably 10 parts by mass or more, still more preferably 15 parts by mass or more, even more preferably 20 parts by mass or more, relative to 100 parts by mass in total of the compound (D) and the compound (E). The amount of the fluorine-free epoxy resin is preferably 90 parts by mass or less, more preferably 80 parts by mass or less, still more preferably 70 parts by mass or less, even more preferably 60 parts by mass or less, relative to 100 parts by mass in total of the compound (D) and the compound (E). The fluorine-free epoxy resin may be any fluorine-free epoxy resin mentioned for the later-described curable composition.

The composition may or may not contain an organic solvent, and preferably has an organic solvent content of 1% by mass or lower in terms of a filler, a sealant, and an adhesive. The composition can contain a compatible blend of the compound (D) and the compound (E), which are fluorine-containing epoxy resins, with the fluorine-free epoxy resin, even when having an organic solvent content of 1% by mass or lower. The organic solvent content may be 0.5% by mass or lower, 0.3% by mass or lower, 0.1% by mass or lower, 0.01% by mass or lower, or substantially 0% by mass. The organic solvent may be any organic solvent mentioned for the later-described curable composition.

The composition may further contain a curing agent or a cationic or anionic polymerization initiator (catalyst). The amounts thereof are the same as those in the curable composition described later.

The disclosure also relates to a curable composition containing the first or second composition of the disclosure and a curing agent.

The curing agent is preferably a curing agent for an epoxy resin. The curing agent for an epoxy resin is preferably includes at least one selected from the group consisting of an acid anhydride, an amine, an isocyanate, an amide, an imidazole, and a mercaptan.

Specific examples of the curing agent for an epoxy resin include 4,4'-diaminodicyclohexylmethane, 1,4-diaminocyclohexane, 2,6-diaminopyridine, m-phenylenediamine, p-phenylenediamine, 4,4'-diaminodiphenylmethane, 2,2'-bis(4-aminophenyl)propane, benzine, 4,4'-diaminophenyl oxide, 4.4'-diaminophenyl sulfone, bis(4-aminophenyl)methyl phosphine oxide, bis(4-aminophenyl)phenyl phosphine oxide, bis(4-aminophenyl)methyl amine, 1,5-diaminonaphthalene, m-xylylenediamine, 1,1'-bis(p-aminophenyl)phthalan, p-xylylenediamine, hexamethylenediamine, 6,6'-diamino-2,2'-dipyridyl, 4,4'-diaminobenzophenone, 4,4'-diaminoazobenzene, bis(4-aminophenyl)phenyl methane, 1,1-bis(4-aminophenyl)cyclohexane, 1,1-bis(4-amino-3-methyl phenyl)cyclohexane, 2,5-bis(m-aminophenyl)-1,3,4-oxadiazole, 2,5-bis(p-aminophenyl)-1,3,4-oxadiazole, 2,5-bis(p-aminophenyl)-1,3,4-oxadiazole, 5,5-di(m-aminophenyl)-(2,2')bis(1,3,4-oxadiazolyl), 4,4'-diaminodiphenyl ether, 4,4'-bis(p-aminophenyl)-2,2'-dithiazole, m-bis(4-p-aminophenyl-2-thiazolyl)benzene, 4,4'-diaminobenzanilide, 4,4'-diaminophenylbenzoate, N,N'-bis(4-aminobenzyl)-p-phenylenediamine, 4,4'-methylene bis(2-dichloroaniline), benzoguanamine, methylguanamine, tetramethylbutanediamine, phthalic anhydride, trimellitic anhydride, pyromellitic anhydride, benzophenonetetracarboxylic anhydride, ethylene glycol bis(anhydrotrimellitate), glycerol tris(anhydrotrimellitate), maleic anhydride, 2-methylimidazole, 2-phenylimidazole, 2-ethyl-4-methylimidazole, 2-undecylimidazole, and a boron trifluoride complex. These may be used alone or in combination of two or more thereof.

Examples of the curing agent for an epoxy resin include, although some of the following have already been exemplified, polyamines, polycarboxylic acids, acid anhydrides, and phenols, as well as imidazoles, polymercaptans, and organic acid hydrazides.

Examples of polyamines include diethylenetriamine, dipropylenetriamine, triethylenetetramine, tetraethylenepentamine, dimethylaminopropylamine, diethylaminopropylamine, dibutylaminopropylamine, hexamethylenediamine, N-aminoethylpiperazine, trimethylhexamethylenediamine, bis-(hexamethylene)triamine, polyoxypropylenediamine, 3,3'-dimethyl-4,4'-diaminodicyclohexylmethane, 3-amino-1-cyclohexylaminopropane, 4,4'-diaminodicyclohexylmethane, isophoronediamine, 1,3-bis(aminomethyl)cyclohexane, a mixture of N-dimethylcyclohexylaminopropane and 4,4'-diaminodicyclohexylaminopropane, 4,4'-diaminodiphenylmethane, 4,4'-diaminodiphenyl ether, diaminodiphenylsulfone, m-phenylenediamine, 2,4-toluylenediamine, 2,6-toluylenediamine, 2,3-toluylenediamine, 3,4-toluylenediamine, methaxylylenediamine, xylylenediamine, dicyandiamide, and diacetone acrylamide.

Examples of polycarboxylic acids include phthalic acid, hydroxyisophthalic acid, succinic acid, sebacic acid, maleic acid, dodecenylsuccinic acid, chlorendic acid, pyromellitic acid, trimellitic acid, hexahydrophthalic acid, methylhexahydrophthalic acid, tetrahydrophthalic acid, methyltetrahydrophthalic acid, and methylnadic acid.

Examples of acid anhydrides include maleic anhydride, dodecenylsuccinic anhydride, chlorendic anhydride, sebacic anhydride, phthalic anhydride, pyromellitic anhydride, trimellitic anhydride, cyclopentane-tetracarboxylic dihydride, hexahydrophthalic anhydride, methylhexahydrophthalic anhydride, tetramethylenemaleic anhydride, tetrahydrophthalic anhydride, methyltetrahydrophthalic anhydride, endomethylenetetrahydrophthalic anhydride, methylendomethylenetetrahydrophthalic anhydride, 5-(2,5-dioxotetrahydroxyfuryl)-3-methyl-3-cyclohexene-1,2-dicarboxylic anhydride, and methylnadic anhydride.

Examples of phenols include various polyhydric phenols including bisphenol A, bisphenol F, bisphenol S, bisphenol AD, hydroquinone, resorcinol, methyl resorcinol, biphenol, tetramethyl biphenol, dihydroxy naphthalene, dihydroxy diphenyl ether, thiodiphenols, phenol novolac resin, cresol novolac resin, phenol aralkyl resin, biphenyl aralkyl resin, naphthol aralkyl resin, terpene phenolic resin, dicyclopentadiene phenolic resin, bisphenol A novolac resin, trisphenol methane resin, naphthol novolac resin, brominated bisphenol A, and brominated phenol novolac resin; polyhydric phenolic resins obtainable by a condensation reaction of a phenol and an aldehyde such as benzaldehyde, hydroxy benzaldehyde, crotonaldehyde, or glyoxal; polyhydric phenolic resins obtainable by a condensation reaction of a xylene resin and a phenol; cocondensated resins of heavy oil or a pitch, a phenol, and a formaldehyde; and various phenolic resins such as a phenol/benzaldehyde/xylylene dimethoxide polycondensate, a phenol/benzaldehyde/xylylene dihalide polycondensate, a phenol/benzaldehyde/4,4'-dimethoxidebiphenyl polycondensate, and a phenol/benzaldehyde/4,4'-dihalide biphenyl polycondensate.

The curing agents for an epoxy resin may be used alone or in combination of two or more thereof. In an embodiment, the curable composition of the disclosure preferably contains the curing agent for an epoxy resin in an amount of 0.01 to 10 equivalents, more preferably 0.1 to 5 equivalents, still more preferably 0.5 to 2 equivalents in terms of the equivalent ratio relative to the total of the compound (D) and the compound (E). Such an embodiment is preferred in terms of curability.

The curable composition of the disclosure also preferably contains a curing catalyst (curing accelerator) in place of or in addition to the curing agent for an epoxy resin. The curing catalyst may be a cationic or anionic polymerization initiator (catalyst). The cationic polymerization initiator (catalyst) and the anionic polymerization initiator (catalyst) are each a compound that initiates and/or promotes a curing reaction of a curable composition by heating or light irradiation. The cationic polymerization initiator (catalyst) may be any cationic polymerization initiator that generates cationic species such as Brønsted acids and Lewis acids by heating or light irradiation. Examples of the cationic polymerization initiator (catalyst) include an onium salt, a protonic acid ester, and a complex of a Lewis acid and an amine. These cationic polymerization initiators (catalysts) may be used alone or in combination of two or more thereof.

The anionic polymerization initiator (catalyst) may be any anionic polymerization initiator that generates anionic species such as Brønsted bases and Lewis bases by heating or light irradiation. Examples of the anionic polymerization initiator (catalyst) include imidazole and a tertiary amine. These anionic polymerization initiators (catalysts) may be used alone or in combination of two or more thereof.

The amount of the curing catalyst is preferably 0.1 parts by mass or more, more preferably 1 part by mass or more, still more preferably 2 parts by mass or more, even more preferably 3 parts by mass or more, relative to 100 parts by mass in total of the compound (D), the compound (E), and a fluorine-free epoxy resin contained as needed. The amount of the curing catalyst is preferably 15 parts by mass or less, more preferably 10 parts by mass or less, still more preferably 7 parts by mass or less, relative to 100 parts by mass in total of the compound (D) and the compound (E).

The curable composition of the disclosure preferably further contains a fluorine-free epoxy resin. The fluorine-free epoxy resin may include components including a typical fluorine-free epoxy resin such as a bisphenol A epoxy resin, a brominated bisphenol A epoxy resin, or a novolac epoxy resin, and an epoxy curing agent. Examples of the fluorine-free epoxy resin include, although some of the following have been already exemplified above, a hydrogenated epoxy resin, an alicyclic epoxy resin, an epoxy resin containing an isocyanurate ring, a bisphenol A epoxy resin, a bisphenol F epoxy resin, a phenol novolac epoxy resin, a cresol novolac epoxy resin, a naphthalene epoxy resin, a biphenyl epoxy resin, a phenol aralkyl epoxy resin, a biphenyl aralkyl epoxy resin, a hydrogenated epoxy resin obtained by hydrogenating the aromatic rings of any of these epoxy resins, and a dicyclopentadiene epoxy resin.

In particular, the fluorine-free epoxy resin is preferably a compound represented by the following formula: 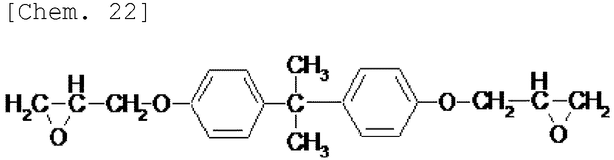 or a compound represented by the following formula: 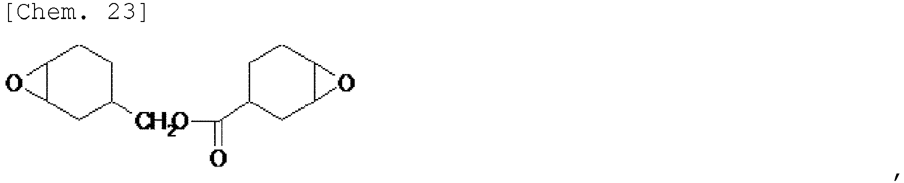 particularly preferably a compound represented by the following formula:

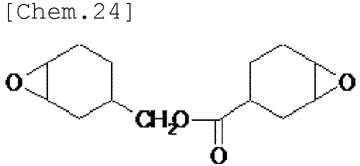

The amount of the fluorine-free epoxy resin is preferably 5 parts by mass or more, more preferably 10 parts by mass or more, still more preferably 15 parts by mass or more, even more preferably 20 parts by mass or more, relative to 100 parts by mass in total of the compound (D) and the compound (E). The amount of the fluorine-free epoxy resin is preferably 90 parts by mass or less, more preferably 80 parts by mass or less, still more preferably 70 parts by mass or less, even more preferably 60 parts by mass or less, relative to 100 parts by mass in total of the compound (D) and the compound (E).

The curable composition of the disclosure may or may not contain an organic solvent, and preferably has an organic solvent content of 1% by mass or lower in terms of a filler, a sealant, and an adhesive. The curable composition of the disclosure can contain a compatible blend of the compound (D) and the compound (E), which are fluorine-containing epoxy resins, with the fluorine-free epoxy resin even when having an organic solvent content of 1% by mass or lower. The organic solvent content may be 0.5% by mass or lower, 0.3% by mass or lower, 0.1% by mass or lower, 0.01% by mass or lower, or substantially 0% by mass.

Examples of the organic solvent include toluene, xylene, acetone, methyl ethyl ketone, methyl isobutyl ketone, ethyl acetate, dimethyl formamide, and N-methylpyrrolidone. These may be used alone or in combination of two or more thereof.

The disclosure further provides a cured product obtainable by curing the curable composition of the disclosure. Since the cured product of the disclosure is obtainable by curing the curable composition, the cured product has a low permittivity and a low loss tangent, and is excellent in total light transmittance, haze value, refractive index, and heat resistance. In addition, the cost can be reduced as compared with the case where the curable composition is not used in combination with a fluorine-free epoxy resin.

The cured product of the disclosure preferably has a relative permittivity of 4.0 or lower. The relative permittivity is more preferably 3.9 or lower, particularly preferably 3.8 or lower. The lower limit of the relative permittivity may be, but is not limited to, for example, 2.5 or higher or 3.0 or higher. The relative permittivity is the value obtained by depositing aluminum on both sides of a cured product in a vacuum and determining the capacitance with an LCR meter at 25°C and a frequency of 1 kHz.

The lower limit of the relative permittivity at a frequency of 10 GHz may be, for example, 2.0 or higher or 2.5 or higher. The upper limit is the same as in the case of a frequency of 1 kHz. The relative permittivity at a frequency of 10 GHz is the value obtained by determination by the coaxial resonator method.

The cured product of the disclosure preferably has a loss tangent of 0.05 or lower. The loss tangent is more preferably 0.03 or lower, still more preferably 0.02 or lower, particularly preferably 0.015 or lower. The lower limit of the loss tangent may be, but is not limited to, for example, 0.001 or higher or 0.002 or higher. The loss tangent is the value obtained by depositing aluminum on both sides of a cured product in a vacuum and determining the capacitance with an LCR meter at 25°C and a frequency of 1 kHz. The upper limit of the loss tangent at a frequency of 10 GHz is preferably 0.05 or lower. The loss tangent is more preferably 0.04 or lower, more preferably 0.03 or lower, particularly preferably 0.02 or lower. The lower limit is the same as in the case of a frequency of 1 kHz. The loss tangent at a frequency of 10 GHz is the value obtained by determination by the coaxial resonator method.

The cured product of the disclosure preferably has a transmittance of 80% or higher, more preferably 90% or higher, at a thickness of 100 µm and a wavelength of 550 nm. The upper limit may be, but is not limited to, for example, 98%. The transmittance is the value measured with a spectrophotometer. A cured product having a thickness of 100 µm or greater and a transmittance of 80% or higher can be regarded as one having a transmittance of 80% or higher at a thickness of 100 µm.

The cured product of the disclosure preferably has a refractive index of 1.35 to 1.55. The refractive index is more preferably 1.52 or lower, still more preferably 1.49 or lower, and may be 1.40 or higher or 1.42 or higher. The refractive index is the value measured with an Abbe refractometer.

The cured product of the disclosure may be a coating film. The coating film may be formed by applying the curable composition of the disclosure, and then drying the coating film or firing the coating film. The drying is preferably performed at a temperature of 70°C to 200°C for 5 to 60 minutes or 1 to 12 hours. The firing is preferably performed at a temperature of 80°C to 300°C for 10 to 90 minutes or 1 to 12 hours. The coating film may have any thickness appropriately set according to the intended use, and may have a thickness of 1 to 1000 µm, for example. The substrate may be any substrate appropriately selected according to the intended use, and examples thereof include substrates made of aluminum, stainless steel, copper, iron, polyimide, polyester, polyamide, glass cloth, or glass.

In the case of forming a cured product other than the coating film, the method may be pressure compression molding.

For example, the curable composition of the disclosure is applied to a sheet substrate by impregnation, and the workpiece is dried at room temperature to 160°C, whereby a prepreg without adhesion can be obtained. The temperature for drying is decided according to the solvent and curing agent used.

Next, a necessary number of the obtained prepregs are stacked and are then subjected to a heat curing reaction at 100°C to 250°C and a pressure of 1 to 100 kgf/cm², whereby a laminate can be obtained. The number of layers stacked is not limited and is typically 2 to 50 layers when the laminate is used for a printed wiring board, for example. The disclosure also provides a printed wiring board including a prepreg obtained by impregnation coating a sheet substrate with the curable composition of the disclosure.

The sheet substrate may be almost any sheet substrate typically used for a stacking material. The sheet substrate usually has a thickness of 0.03 to 10 mm, preferably 0.03 to 1 mm, although not being limited thereto. Examples of the sheet substrate include knitted or woven fabrics and non-woven fabrics of inorganic fibers such as glass fibers and carbon fibers and organic fibers such as Kevlar fibers (aromatic polyamide available from Du Pont), and sheets of polytetrafluoroethylene porous material. Preferred examples of the sheet substrate include glass cloths made of glass fibers such as E-glass, C-glass, A-glass, S-glass, D-glass, and YM-31-A glass each containing SiO₂ and Al₂O₃ as components, and Q-glass containing quartz.

The cured product of the disclosure is obtained from a curable composition containing the compound (D) and the compound (E), and thus can achieve a lower relative permittivity, a lower loss tangent, a lower haze value, and a higher total light transmittance. The cured product also has excellent mechanical strength and excellent heat resistance, for example. The cured product is thus suitable as a material for electronic materials, particularly as a low permittivity material. The cured product of the disclosure is preferably an electronic material. The cured product of the disclosure may be applied to any electronic component and is useful for high-frequency printed boards that are to have high frequency properties. Examples of high-frequency printed boards include substrates of electronic devices such as an antenna, a radar system, a router in networking, a backplane, and a wireless infrastructure; substrates for automotive sensors; and substrates for engine management sensors. The cured product is particularly suitable for applications for reducing the transmission loss in the millimeter-wave band.

Also, the cured product of the disclosure can be used for a paste, a B-stage film, and an electronic material for resin-coated copper foil or a prepreg for a printed board, particularly for a high-frequency multilayer substrate and a buildup insulating material.

Since the cured product of the disclosure also has high transparency, the cured product is useful as an optical material for optical devices, such as an optical waveguide material or a material for a sealing member necessary for processing an optical device, and also for an optical material for display devices, such as an antireflection film. The cured product can also be used as an adhesive for optical components and elements.

### EXAMPLES

The disclosure is described with reference to examples, but the examples are not intended to limit the disclosure.

The parameters in the examples were determined as follows.

Physical properties of composition:

### [Transparency]

Each composition was poured into a 1-cm-square cell made of quartz and the transmittance at 550 nm was measured using a Hitachi spectrophotometer (trade name: U-4100, available from Hitachi High-Technologies Corporation). The air was used as the reference.

### [Fluorine content]

The fluorine content (% by mass) was determined by burning 10 mg of a sample by the oxygen flask combustion method, causing the gases from the decomposition to be absorbed by 20 ml of deionized water, and measuring the fluorine ion concentration in the absorption solution by the fluorine selective electrode method.

### Film properties:

### [Electrical properties]

(1) Measurement of electrical properties at frequencies of 1 kHz and 10 kHz

### [Relative permittivity]

Aluminum is deposited on both sides of a film in a vacuum to prepare a sample. The capacitance of the sample is measured with an LCR meter at 25°C and frequencies of 1 kHz and 10 kHz. The relative permittivity was calculated from each of the obtained capacitances.

### [Dissipation factor]

Aluminum is deposited on both sides of a film in a vacuum to prepare a sample. The loss tangent of the sample is measured with an LCR meter at 25°C and frequencies of 1 kHz and 10 kHz.

(2) Measurement of electrical properties at frequency of 10 GHz

### [Relative permittivity]

The relative permittivity of a film was calculated by measuring the change in the resonance characteristics (resonance frequency, Q value) of a resonator at 25°C and a frequency of 10 GHz, with a measuring device based on the coaxial resonator method.

### [Dissipation factor]

The loss tangent of a film was calculated by measuring the change in the resonance characteristics (resonance frequency, Q value) of a resonator at 25°C and a frequency of 10 GHz, with a measuring device based on the coaxial resonator method.

### [Appearance]

(1) The appearance of a composition was visually evaluated. The evaluation criteria are as follows.
   3: Colorless and transparent
   2: A little cloudy but transparent (semitransparent)
   1: Cloudy or phase separated
(2) The appearance of the cured product was visually evaluated. The evaluation criteria are as follows.
   3: Transparent
   2: A little cloudy (semitransparent)
   1: Cloudy

### [Refractive index]

The refractive index at 23°C of the prepared film was measured with an Abbe refractometer (NAR-1T SOLID) available from Atago Co., Ltd. Since the LED attached to the device was used, the wavelength was approximate to that of the D line.

The following materials were used in examples and comparative examples.

### Compound (1): Fluorine-containing epoxy compound

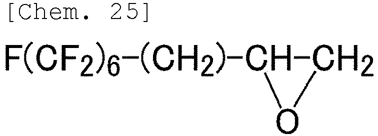

### Compound (2): Alicyclic fluorine-containing epoxy compound

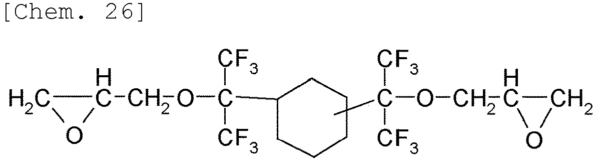

The cured product of the compound (2) has an epoxy equivalent of 264, a glass transition temperature of 127°C, a coefficient of linear expansion of 60 ppm, a relative permittivity of 3.24, a loss tangent of 0.0096, and a refractive index of 1.42.

These values are the values of a specimen obtained by adding 2 parts by mass of 2-ethyl-4-methyl imidazole to 100 parts by mass of the compound (2), heating the components to 50°C, uniformly mixing it to provide a curable composition, and curing the composition at 200°C for five hours.

The epoxy equivalent is the value determined by the method in conformity with JIS K-7236. The glass transition temperature is the value determined as the middle point of an endothermic curve of second run, the endothermic curve being obtained by performing temperature rising (first run) - temperature dropping - temperature rising (second run) at a temperature-changing rate of 10°C/min in a temperature range from 30°C to 250°C using a differential scanning calorimeter (DSC, available from SEIKO, RTG220). The coefficient of linear expansion is the value determined by thermomechanical analysis (TMA). The relative permittivity is the value calculated by determining the capacitance with an LCR meter at 25°C and a frequency of 1 kHz. The loss tangent is the value measured with an LCR meter at 25°C and a frequency of 1 kHz. The refractive index is the value measured with an Abbe refractometer.

### Compound (3): Fluorine-free epoxy compound

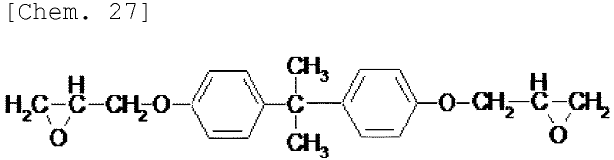

### Compound (4): Fluorine-free epoxy compound

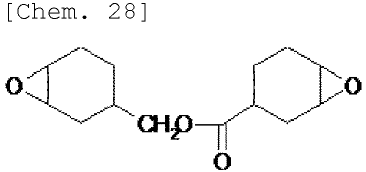

### Compound (5): Curing agent (acid anhydride)

HN-5500 available from Hitachi Kasei Co., Ltd. (3- or 4-methyl-hexahydrophthalic anhydride)

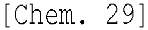

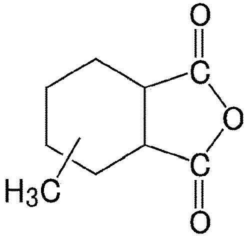

### Compound (6) Curing accelerator

DBU phenol salt (available from San Apro Co., Ltd., product number "U-CAT SA1") (tertiary amine)

### Compound (7): Aromatic fluorine-containing epoxy compound

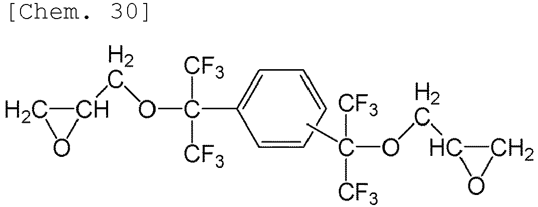

The cured product of the compound (7) has an epoxy equivalent of 261, a glass transition temperature of 111°C, a coefficient of linear expansion of 50 ppm, a relative permittivity of 3.3, a loss tangent of 0.0088, and a refractive index of 1.45.

These values are the values of a specimen obtained by adding 2 parts by mass of 2-ethyl-4-methyl imidazole to 100 parts by mass of the compound (7), heating the components to 50°C, uniformly mixing it to provide a curable composition, and curing the composition at 200°C for five hours.

The epoxy equivalent is the value determined by the method in conformity with JIS K-7236. The glass transition temperature is the value determined as the middle point of an endothermic curve of second run, the endothermic curve being obtained by performing temperature rising (first run) - temperature dropping - temperature rising (second run) at a temperature-changing rate of 10°C/min in a temperature range from 30°C to 250°C using a differential scanning calorimeter (DSC, available from SEIKO, RTG220). The coefficient of linear expansion is the value determined by thermomechanical analysis (TMA). The relative permittivity is the value calculated by determining the capacitance with an LCR meter at 25°C and a frequency of 1 kHz. The loss tangent is the value measured with an LCR meter at 25°C and a frequency of 1 kHz. The refractive index is the value measured with an Abbe refractometer.

### Compound (8) Curing accelerator

4-Dimethylaminopyridine (DMAP) (tertiary amine)

### Example 1

The compound (2) was used as a compatibilizer for the compound (1) to prepare a composition 1 having a mass ratio of compound (1):compound (2) of 50:50. The composition 1 had a colorless, transparent appearance evaluated as 3 points. The fluorine content was 54%. Table 1 shows the results.

In Tables 1 to 4, the unit of the values for the compounds (1) to (4) and SAN-AID SI-60L is "part(s) by mass".

### Example 2

The composition 1 obtained in Example 1 and the compound (4) were mixed at a compounding mass ratio composition 1:compound (4) of 80:20 to obtain a composition 2. The composition 2 was substantially free from a solvent, had a colorless, transparent appearance evaluated as 3 points, and had very high uniformity. The fluorine content was 44%. Table 1 shows the results.

### Example 3

A film (composition 3) having a film thickness of about 200 µm was obtained by adding 2 parts by mass of SAN-AID SI-60L (available from Sanshin Chemical Industry Co., Ltd.) as an epoxy curing agent to 100 parts by mass of the composition 2, uniformly mixing it, coating a PET film with the mixture, and curing the mixture at 90°C for two hours. The obtained film was a transparent coating film. The appearance, transmittance at 550 nm, and refractive index of the film were measured. Table 1 shows the results. In addition, the permittivity and the loss tangent were measured at 1 kHz and 10 kHz. Table 1 shows the results.

**[Table 1]**

| | Example 1 | Example 2 | Example 3 |
|---|---|---|---|
| Compound (1) | 40 | 40 | 40 |
| Compound (2) | 40 | 40 | 40 |
| Compound (3) | - | - | - |
| Compound (4) | - | 20 | 20 |
| SAN-AID SI-60L | - | - | 2 |
| Composition used | - | Composition 1 | Composition 2 |
| Composition obtained | Composition 1 | Composition 2 | Composition 3 |
| Appearance | 3 | 3 | 3 |
| Transmittance | - | - | 93.1 |
| Fluorine content | 54 | 44 | - |
| Refractive index | - | - | 1.445 |
| Relative permittivity (1 kHz) | - | - | 3.6 |
| Relative permittivity (10 kHz) | - | - | 3.4 |
| Dissipation factor (1 kHz) | - | - | 0.017 |
| Dissipation factor (10 kHz) | - | - | 0.010 |

### Examples 4, 7, 10, 13 and 16

Compositions 4, 7, 10, 13 and 16 each were obtained and evaluated in the same manner as in Example 1, except that the compounding ratio between the compounds (1) and (2) was varied as shown in Table 2 or 3. Tables 2 and 3 show the results.

### Examples 5, 8, 11, 14 and 17

Compositions 5, 8, 11, 14, and 17 were obtained in the same manner as in Example 2, except that the compositions 4, 7, 10, 13, and 16, respectively, were used in place of the composition 1. Tables 2 and 3 show the results.

### Examples 6, 9, 12 and 15

Compositions 6, 9, 12, and 15 were obtained in the same manner as in Example 3, except that the compositions 5, 8, 11, and 14, respectively, were used in place of the composition 2. Tables 2 and 3 show the results.

**[Table 2]**

| | Example 4 | Example 5 | Example 6 | Example 7 | Example 8 | Example 9 |
|---|---|---|---|---|---|---|
| Compound (1) | 50 | 50 | 50 | 45 | 45 | 45 |
| Compound (2) | 30 | 30 | 30 | 35 | 35 | 35 |
| Compound (3) | - | - | - | - | - | - |
| Compound (4) | - | 20 | 20 | - | 20 | 20 |
| SAN-AID SI-60L | - | - | 2 | - | - | 2 |
| Composition used | - | Composition 4 | Composition 5 | - | Composition 7 | Composition 8 |
| Composition obtained | Composition 4 | Composition 5 | Composition 6 | Composition 7 | Composition 8 | Composition 9 |
| Appearance | 3 | 3 | 3 | 3 | 3 | 3 |
| Transmittance | - | - | 92.0 | - | - | 93.3 |
| Fluorine content | 57 | 46 | - | 55 | 45 | - |
| Refractive index | - | - | 1.481 | - | - | 1.456 |
| Relative permittivity (1 kHz) | - | - | 3.8 | - | - | - |
| Relative permittivity (10 kHz) | - | - | 3.7 | - | - | - |
| Dissipation factor (1 kHz) | - | - | 0.015 | - | - | - |
| Dissipation factor (10 kHz) | - | - | 0.010 | - | - | - |

**[Table 3]**

| | Example 10 | Example 11 | Example 12 | Example 13 | Example 14 | Example 15 | Example 16 | Example 17 |
|---|---|---|---|---|---|---|---|---|
| Compound (1) | 30 | 30 | 30 | 20 | 20 | 20 | 25 | 25 |
| Compound (2) | 50 | 50 | 50 | 60 | 60 | 60 | 25 | 25 |
| Compound (3) | - | - | - | - | - | - | - | - |
| Compound (4) | - | 20 | 20 | - | 20 | 20 | 50 | 50 |
| SAN-AID SI-60L | - | - | 2 | - | - | 2 | - | 2 |
| Composition used | - | Composition 10 | Composition 11 | - | Composition 13 | Composition 14 | - | Composition 16 |
| Composition obtained | Composition 10 | Composition 11 | Composition 12 | Composition 13 | Composition 14 | Composition 15 | Composition 16 | Composition 17 |
| Appearance | 3 | 3 | 3 | 3 | 3 | 3 | 3 | 3 |
| Transmittance | - | - | - | - | - | - | - | - |
| Fluorine content | 51 | 41 | - | 49 | 39 | - | 27 | - |
| Refractive index | - | - | - | - | - | - | - | - |
| Relative permittivity (1 kHz) | - | - | - | - | - | 3.9 | - | - |
| Relative permittivity (10 kHz) | - | - | - | - | - | 3.7 | - | - |
| Dissipation factor (1 kHz) | - | - | - | - | - | - | - | - |
| Dissipation factor (10 kHz) | - | - | - | - | - | - | - | - |

### Example 18

A composition 18 was prepared in the same manner as in Example 2, except that the compound (3) and the compound (4) were used in combination as shown in Table 4. Table 4 shows the results.

### Example 19

A composition 19 was prepared in the same manner as in Example 3, except that the composition 18 was used. Table 4 shows the evaluation results.

### Example 20

A composition 20 was prepared in the same manner as in Example 4, except that the compound (3) and the compound (4) were used in combination as shown in Table 4. Table 4 shows the results.

### Example 21

A composition 21 was prepared in the same manner as in Example 3, except that the composition 20 was used. Table 4 shows the results.

**[Table 4]**

| | Example 18 | Example 19 | Example 20 | Example 21 |
|---|---|---|---|---|
| Compound (1) | 40 | 40 | 50 | 50 |
| Compound (2) | 40 | 40 | 30 | 30 |
| Compound (3) | 2 | 2 | 2 | 2 |
| Compound (4) | 18 | 18 | 18 | 18 |
| SAN-AID SI-60L | - | 2 | - | 2 |
| Composition used | - | Composition 18 | - | Composition 20 |
| Composition obtained | Composition 18 | Composition 19 | Composition 20 | Composition 21 |
| Appearance | 3 | 3 | 3 | 3 |
| Transmittance | - | - | - | - |
| Fluorine content | 43 | - | 45 | - |
| Refractive index | - | - | - | - |

### Comparative Example 1

A composition having a mass ratio of compound (1):compound (4) of 80:20 was produced. The composition had a cloudy appearance evaluated as 1 point, and separated into two layers over time. Such a composition is difficult to cure uniformly, thus being unsuitable for the applications intended by the invention of the disclosure.

### Comparative Example 2

A composition having a mass ratio of compound (1):compound (4) of 50:50 was produced. The composition had a cloudy appearance evaluated as 1 point, and separated into two layers over time. Such a composition is difficult to cure uniformly, thus being unsuitable for the applications intended by the invention of the disclosure.

### Comparative Example 3

A composition having a mass ratio of compound (1):compound (3) of 80:20 was produced. The composition had a cloudy appearance evaluated as 1 point, and separated into two layers over time. Such a composition is difficult to cure uniformly, thus being unsuitable for the applications intended by the invention of the disclosure.

### Comparative Example 4

A composition having a mass ratio of compound (1):compound (3) of 50:50 was produced. The composition had a cloudy appearance evaluated as 1 point, and separated into two layers over time. Such a composition is difficult to cure uniformly, thus being unsuitable for the applications intended by the invention of the disclosure.

### [Mixing with curing agent (acid anhydride)]

### Example 22

The compound (5), i.e., an acid anhydride HN5500, in an equivalent amount was added as a curing agent to the composition 2 prepared in Example 2 to prepare a curable composition 22-1. The curable composition 22-1 had a colorless, transparent appearance evaluated as 3 points.

Subsequently, 0.03 parts of the compound (6), i.e., DBU phenol salt (U-CAT SA1 available from San-Apro Co., Ltd.) as a curing accelerator was added to 100 parts of the composition to prepare a curing composition 22-2. Although the curable composition was transparent, the curable composition was colored yellowish brown derived from DBU salt. This curable composition 22-2 was applied to a glass plate and cured at 100°C for 1 hour and at 150°C for 2 hours. The cured product had a colorless, transparent appearance evaluated as 3 points.

### Example 23

A composition 23 was produced by adding the compound (2) as a compatibilizer to the compound (1) such that the mass ratio of compound (1):compound (2):compound (4) was 40:60:20, adding an acid anhydride compound (5) as a curing agent in an equivalent amount to the mixture, and adding the compound (8) as a curing accelerator to the mixture such that the amount thereof was 1 part relative to 100 parts of the entire mixture (total of the compound (1), the compound (2), the compound (4), and the compound (5)). The composition 23 had a colorless, transparent appearance evaluated as 3 points. Table 5 shows the results.

In Tables 5 to 8, the unit of values for the compounds (1) to (8) and SAN-AID SI-60L is "part(s) by mass".

### Example 24

A composition 24 was produced in the same manner as in Example 23, except that the compound (7) was used as a compatibilizer in place of the compound (2). The composition 24 had a little cloudy but transparent appearance evaluated as 2 points. Table 5 shows the results.

**[Table 5]**

| | Example 23 | Example 24 |
|---|---|---|
| Compound (1) | 40 | 40 |
| Compound (2) | 60 | |
| Compound (7) | | 60 |
| Compound (4) | 20 | 20 |
| Compound (5) | 96 | 96 |
| Compound (8) | 2.3 | 2.3 |
| Composition obtained | Composition 23 | Composition 24 |
| Fluorine content | 23 | 23 |
| Appearance | 3 | 2 |

### Example 25

A film (composition 25) having a film thickness of about 500 µm was obtained by coating a PTFE sheet with the composition 23 and curing the composition at 90°C for 1 hour and at 180°C for 2 hours. The obtained film was a brown transparent film. The permittivity and the loss tangent of the film were measured at 10 GHz. Table 6 shows the results.

### Example 26

A film (composition 26) having a film thickness of about 500 µm was obtained by curing the composition 24 in the same manner as in Example 25. The obtained film was a brown transparent film. The permittivity and the loss tangent of the film were measured at 10 GHz. Table 6 shows the results.

**[Table 6]**

| | Example 25 | Example 26 |
|---|---|---|
| Composition used | Composition 23 | Composition 24 |
| Composition obtained | Composition 25 | Composition 26 |
| Relative permittivity (10 GHz) | 2.71 | 2.74 |
| Dissipation factor (10 GHz) | 0.0174 | 0.0162 |

### Example 27

A composition 27 was prepared in the same manner as in Example 18, except that the compound (2) and the compound (7) were used in combination and the compound (3) was not used as shown in Table 7. Table 7 shows the results.

### Example 28

A composition 28 was prepared in the same manner as in Example 19, except that the composition 27 was used. Table 7 shows the results.

### Example 29

A composition 29 was prepared in the same manner as in Example 20, except that the compound (2) and the compound (7) were used in combination and the compound (3) was not used as shown in Table 7. Table 7 shows the results.

### Example 30

A composition 30 was prepared in the same manner as in Example 21, except that the composition 29 was used. Table 7 shows the results.

**[Table 7]**

| | Example 27 | Example 28 | Example 29 | Example 30 |
|---|---|---|---|---|
| Compound (1) | 40 | 40 | 50 | 50 |
| Compound (2) | 15 | 15 | 20 | 20 |
| Compound (7) | 15 | 15 | 10 | 10 |
| Compound (4) | 20 | 20 | 20 | 20 |
| SAN-AID SI-60L | - | 2 | - | 2 |
| Composition used | - | Composition 27 | - | Composition 29 |
| Composition obtained | Composition 27 | Composition 28 | Composition 29 | Composition 30 |
| Appearance | 3 | 3 | 3 | 3 |
| Transmittance | - | - | - | - |
| Fluorine content | 45 | - | 47 | - |
| Refractive index | - | - | - | - |

### Example 31

The compound (2) and the compound (7) were used as compatibilizers for the compound (1) to prepare a composition 31 having a mass ratio of compound (1):compound (2):compound (7) of 50:25:25. The composition 31 had a colorless, transparent appearance evaluated as 3 points. The fluorine content was 58%. Table 8 shows the results.

### Example 32

The composition 31 obtained in Example 31 and the compound (4) were mixed at a compounding mass ratio composition 1:compound (4) of 80:20 to obtain a composition 32. The composition 32 was substantially free from a solvent, had a colorless, transparent appearance evaluated as 3 points, and had very high uniformity. The fluorine content was 44%. Table 8 shows the results.

### Example 33

A film (composition 33) having a film thickness of about 200 µm was obtained by adding 2 parts by mass of SAN-AID SI-60L (available from Sanshin Chemical Industry Co., Ltd.) as an epoxy curing agent to 100 parts by mass of the composition 32, uniformly mixing it, coating a PET film with the mixture, and curing the mixture at 90°C for two hours. The obtained film was a transparent coating film. The appearance of the film was evaluated and the permittivity and loss tangent of the film were measured at 1 kHz and 10 kHz. Table 8 shows the results.

**[Table 8]**

| | Example 31 | Example 32 | Example 33 |
|---|---|---|---|
| Compound (1) | 40 | 40 | 40 |
| Compound (2) | 20 | 20 | 20 |
| Compound (7) | 20 | 20 | 20 |
| Compound (4) | - | 20 | 20 |
| SAN-AID SI-60L | - | - | 2 |
| Composition used | - | Composition 31 | Composition 32 |
| Composition obtained | Composition 31 | Composition 32 | Composition 33 |
| Appearance | 3 | 3 | 3 |
| Transmittance | - | - | - |
| Fluorine content | 58 | 44 | 45 |
| Refractive index | - | - | - |
| Relative permittivity (1 kHz) | - | - | 3.6 |
| Relative permittivity (10 kHz) | - | - | 3.5 |
| Dissipation factor (1 kHz) | - | - | 0.017 |
| Dissipation factor (10 kHz) | - | - | 0.011 |

## Claims

1. A composition comprising:
a compound (D) represented by the following formula (D): 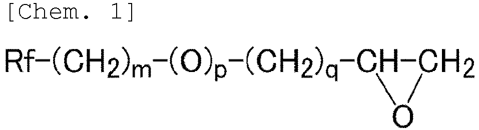 wherein m is an integer of 0 to 6; p is 0 or 1; q is an integer of 0 to 6; Rf is a C1-C8 perfluoroalkyl group optionally containing oxygen with one fluorine atom being optionally replaced by a hydrogen atom; and
a compound (E) represented by the following formula (E) : 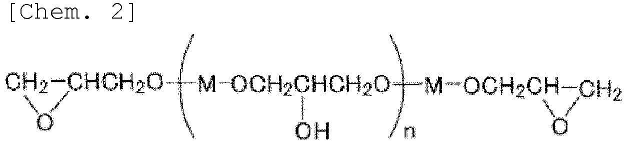 wherein n is an integer of 0 or greater; and M is a group represented by the following formula (E1): 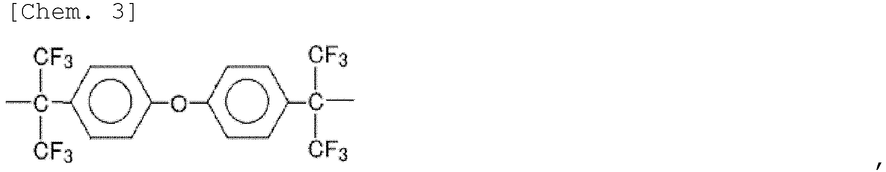 a group represented by the following formula (E2): 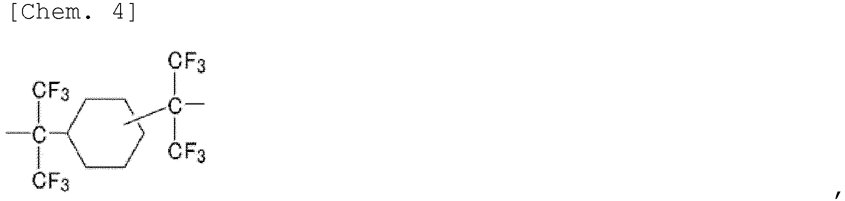 or a group represented by the following formula (E3): 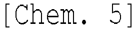 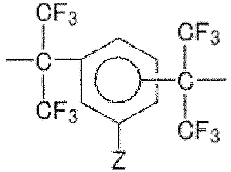 wherein Z is hydrogen or a C1-C10 fluoroalkyl group.

2. The composition according to claim 1,
wherein M is a group represented by the following formula (E2):

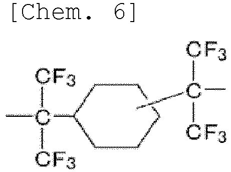

3. The composition according to claim 1 or 2,
wherein Rf is a C6 linear perfluoroalkyl group.

4. The composition according to any one of claims 1 to 3,
wherein the compound (D) represents 5 to 95% by mass of 100% by mass in total of the compound (D) and the compound (E).

5. The composition according to any one of claims 1 to 4,
wherein the composition has an organic solvent content of 1% by mass or lower.

6. A curable composition comprising the composition according to any one of claims 1 to 5 and a curing agent.

7. The curable composition according to claim 6,
wherein the curing agent includes at least one selected from the group consisting of an acid anhydride, an amine, an isocyanate, an amide, an imidazole, and a mercaptan.

8. The curable composition according to claim 6 or 7, further comprising a fluorine-free epoxy resin.

9. A cured product obtainable by curing the curable composition according to any one of claims 6 to 8.

10. The cured product according to claim 9,
wherein the cured product is an electronic material.

11. A composition comprising:
a compound (D) represented by the following formula (D) : 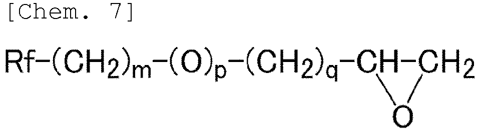 wherein m is an integer of 0 to 6; p is 0 or 1; q is an integer of 0 to 6; and Rf is a C1-C8 perfluoroalkyl group optionally containing oxygen with one fluorine atom being optionally replaced by a hydrogen atom; and
a compatibilizer,
the composition having a fluorine content of 45% by mass or higher.

12. The composition according to claim 11,
wherein the compatibilizer is a fluorine-containing compound comprising two or more epoxy groups and an aromatic ring or cyclohexane ring in a molecular structure.
